## Europäisches Patentamt
## European Patent Office
## Office européen des brevets

(19)

(11) Veröffentlichungsnummer: **0 070 805**
**B1**

(12)

# EUROPÄISCHE PATENTSCHRIFT

(45) Veröffentlichungstag der Patentschrift:
**17.04.85**

(21) Anmeldenummer: **82810303.6**

(22) Anmeldetag: **14.07.82**

(51) Int. Cl.⁴: **H 05 K 13/02**, F 26 B 15/20,
B 41 F 23/04, B 65 G 49/00

(54) **Transportvorrichtung für einseitig flüssigbeschichtetes Material.**

(30) Priorität: **20.07.81 CH 4746/81**

(43) Veröffentlichungstag der Anmeldung:
**26.01.83 Patentblatt 83/4**

(45) Bekanntmachung des Hinweises auf die Patenterteilung:
**17.04.85 Patentblatt 85/16**

(84) Benannte Vertragsstaaten:
**CH DE FR GB LI NL SE**

(56) Entgegenhaltungen:
**US - A - 1 736 866**
**US - A - 3 378 131**
**US - A - 3 700 121**
**US - A - 4 058 908**

(73) Patentinhaber: **CIBA-GEIGY AG, Postfach,
CH-4002 Basel (CH)**

(72) Erfinder: **Kuster, Kaspar, Baselmattweg 203,
CH-4123 Allschwil (CH)**

BUNDESDRUCKEREI BERLIN

## Beschreibung

Die Erfindung betrifft eine Transportvorrichtung gemäß Oberbegriff des Patentanspruchs 1.

Derartige Vorrichtungen werden vor allem für »in die Höhe gebaute« Trockner oder dergleichen verwendet, welche aus raumökonomischen Gründen in neuerer Zeit verstärkt die Tunneltrockner verdrängen. Beim Trocknen von noch flüssigen, insbesondere dünnflüssigen Schichten ist es vor allem wichtig, daß diese über die gesamte Transportstrecke stets genau waagerecht bleiben und auch keine abrupten Geschwindigkeitsänderungen und/oder Vibrationen ausgesetzt werden, da andernfalls die noch flüssige Beschichtungsmasse abfließen oder zumindest die Gleichmäßigkeit der Schicht beeinträchtigt werden kann.

Bei der Herstellung von Lötstoppmasken auf Leiterplatten werden diese mit einem photoempfindlichen Lack beschicht, welcher nach der Trocknung belichtet und entwickelt wird (vgl. z. B. Europäisches Patent Nr. 0 002 040). Dabei kommt es sehr darauf an, daß die Lackschicht möglichst dünn und absolut gleichmäßig ist. Die flüssige Schicht muß daher auch besonders sorgfältig in den festen Zustand überführt werden. Am sichersten gelingt dies, wenn man die frisch beschichteten Leiterplatten eine gewisse Zeit lang (ca. 5 bis 15 Minuten) in völliger Ruhe »ablüften« läßt. In dieser Zeit verdunstet ein so großer Teil des Lösungsmittels des Beschichtungslackes, daß dieser eine ausreichende Festigkeit erreicht, um zur Fertigtrocknung in einem anschließenden Ofen auch stärkeren Luftströmen ausgesetzt werden zu können.

In einem kontinuierlichen Prozeß soll selbstverständlich auch das »Ablüften« kontinuierlich erfolgen. Da die Ablüftphase von Lackschichten relativ lang sein kann, bietet sich aus Gründen der Raumökonomie eine »in die Höhe gebaute« Ablüftvorrichtung an. Zum vollkontinuierlichen Betrieb muß diese mit einer Transportvorrichtung der im Oberbegriff von Anspruch 1 beschriebenen Art ausgestattet sein.

Die bislang bekanntgewordenen Transportvorrichtungen der im Oberbegriff des Anspruchs 1 beschrieben Art konnten einerseits den Anforderungen an die Qualität des Transports (absolut horizontal sowie stoß- und erschütterungsfrei) nicht vollständig genügen und sind anderseits im Aufbau bzw. der Mechanik zu kompliziert, aufwendig und teuer.

Bei einem bekannten Heißluftofen zum Trocknen von bedruckten Blättern oder dergleichen wird das Problem des kombinierten Vertikal-Horizontaltransportes mit ständiger Waagrechthaltung der Blätter während des Transportes durch zwei gegenläufige Lifte und eine Vielzahl Translationsrahmen gelöst. Die Lifte sind durch je 2 Paare einander gegenüberliegende Umlaufketten mit Halterungsleisten gebildet. Die Translationsrahmen sind in die Lifte einschiebbar und werden von deren Halterungsleisten getragen. Oben werden die Translationsrahmen mittels eiener weiteren Kettentransportvorrichtung vom auffahrenden Lift in den abfahrenden geschoben. Das Beladen der Translationsrahmen erfolgt durch ein eingangsseitiges Förderband, welches die zu trocknenden bedruckten Blätter auf den nächsten auffahrenden Translationsrahmen schiebt. Zum Entladen werden die Blätter von den Translationsrahmen abgestreift, wenn diese unten auf den auffahrenden Lift zurückgeschoben werden. Die getrockneten Blätter fallen dann zum Weitertransport auf ein zweites Transportband.

Die vorstehend beschriebene bekannte Anordnung ist einerseits mechanisch ziemlich aufwendig und kann anderseits hohen Anforderungen an die Gleichmäßigkeit erforderlich (siehe weiter oben), trotzdem nicht genügen. Insbesondere die Be- und Entladung der Translationsrahmen und deren obere Translation würden empfindliche Flüssigbeschichtungen kaum unbeschädigt überstehen.

Es sind auch Vorrichtungen bekanntgeworden, z. B. aus den US-Patentschriften 1 736 866, 3 378 131 und 4 058 908, bei denen die Träger für das Transportgut durch an Umlaufketten befestigte Stäbe gebildet sind, die eine Art Grill bilden. Der Horizontaltransport vom aufsteigenden zum absteigenden Ast erfolgt durch Schieber, welche das plattenförmige Transportgut an den Rändern erfassen und von der jeweils obersten Etage des aufsteigenden Astes auf die jeweils oberste Etage des absteigenden Astes schieben. Auch diese Art des Horizontaltransportes ist für viele Anwendungen, insbesondere den Transport von flüssigbeschichteten Leiterplatten viel zu rauh und hat vor allem den Nachteil, daß die Platten am Rand durch den Angriff der Schieber und auf der Unterseite durch das Schieben auf den Grillstäben beschädigt werden können.

Durch die Erfindung sollen die aufgezeigten Mängel beseitigt und eine Transportvorrichtung gemäß Oberbegriff des Patentanspruchs 1 geschaffen werden, welche mit möglichst einfachen mechanischen Mitteln einen praktisch stoß-erschütterungs- und vibrationsfreien Horizontal/Vertikaltransport mit ständiger Waagrechthaltung der Blätter gewährleistet.

Es wurde gefunden, daß diese Aufgabe durch die Anwendung von rechenartigen, »auf Lücke« ineinandergreifenden Trägern für das Transportgut optimal lösbar ist. Die spezielle Anordnung ist im Kennzeichen des Patentanspruchs 1 beschrieben.

Im folgenden wird die Erfindung anhand eines in den Figuren dargestellten Ausführungsbeispiels näher erläutert; es zeigt

Fig. 1 eine vereinfachte schaubildliche Gesamtdarstellung der Vorrichtung,

Fig. 2 ein Detail der Fig. 1,

Fig. 3 eine weitere vereinfachte Vorderansicht der Vorrichtung zur besseren Erläuterung der Bewegungsabläufe,

Fig. 4 einen Schnitt längs der Linie IV-IV der Fig. 3.

Die dargestellte Anordnung umfaßt: eine im wesentlichen vertikale endlose Transportkette 1 mit Vertikaltransportrechen VTR, eine im wesentlichen horizontale endlose zweite Transportkette 3 mit einem Horizontaltransportrechen HTR sowie zwei horizontale Rollenstraßen 5 und 6.

Die beiden Transportketten 1 und 3 sind über je ein Paar Umlenk-Kettenräder 7 und 8 bzw. 9 und 10 geführt. Der Antrieb erfolgt mittels eines Variators 11 (Elektromotor mit stufenloser Drehzahlregelung). Dieser treibt über einen Flachriemen 12 das Kettenrad 9 und damit die Horizontaltransportkette 3 an. Das zweite Umlenk-Kettenrad 10 der Horizontaltransportkette treibt über einen Kettentrieb 13 ein Getriebe 14 (starre Übersetzung), eine Welle 15 und einen weiteren Kettentrieb 16 das obere Umlenkkettenrad 8 der Vertikaltransportkette 1 an.

In den Rollenstraßen 5 und 6 sind die Rollen 50 bzw. 60 in je zwei Gruppen 5a und 5b bzw. 6a und 6b aufgeteilt, wobei jede dieser Gruppen von je einem separaten Motor 50a, 50b, 60a bzw. 60b antreibbar ist.

Jeder Vertikaltransportrechen VTR besteht aus einem Tragarm 2a und senkrecht zu diesem stehenden Zinken 2b. Die Tragarme 2a sind nach außen weisend jeweils genau in der Mitte eines Gliedes 1a der Vertikaltransportkette 1 befestigt, so daß ihre Zinken 2b genau parallel zu den Achsen der Umlenk-Kettenräder 7 und 8 verlaufen.

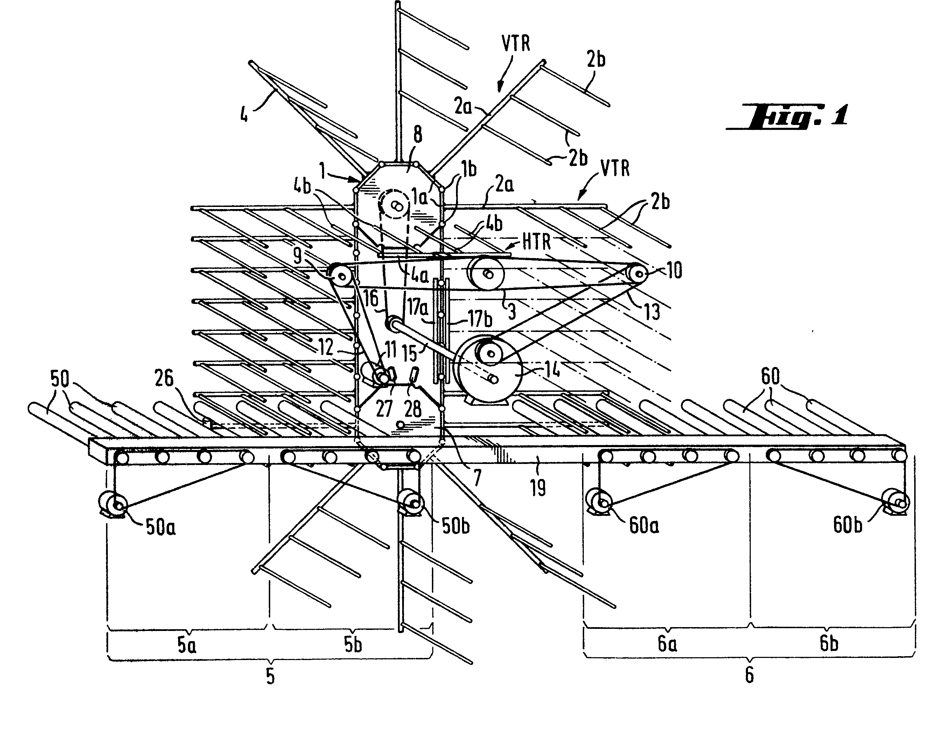

Die genau mittige Befestigung der Transportrechen VTR an den Gliedern 1a der Vertikaltransportkette 1 hat den Vorteil, daß sich die Kräfte (Drehmomente) in den Gelenken 1b der Kette gegenseitig aufheben, sofern alle Rechen VTR mit demselben Gewicht beladen sind und die Schwerpunkte dieser Gewichte alle im selben Abstand von der Kette liegen. Auf die Kettengelenke 1b wirken dann nur die reinen Zugkräfte. Diese Idealbedingungen sind jedoch im Betrieb nicht immer exakt erfüllt. Um im Betrieb auftretende Unregelmäßigkeiten zu kompensieren läuft die Vertikaltransportkette 1 längs ihren beiden Vertikalstrecken in Seitenführungen 17a/ 17b, von denen in Fig. 1 aus zeichnerischen Gründen nur auf einer Seite (rechts) ein Teil dargestellt ist.

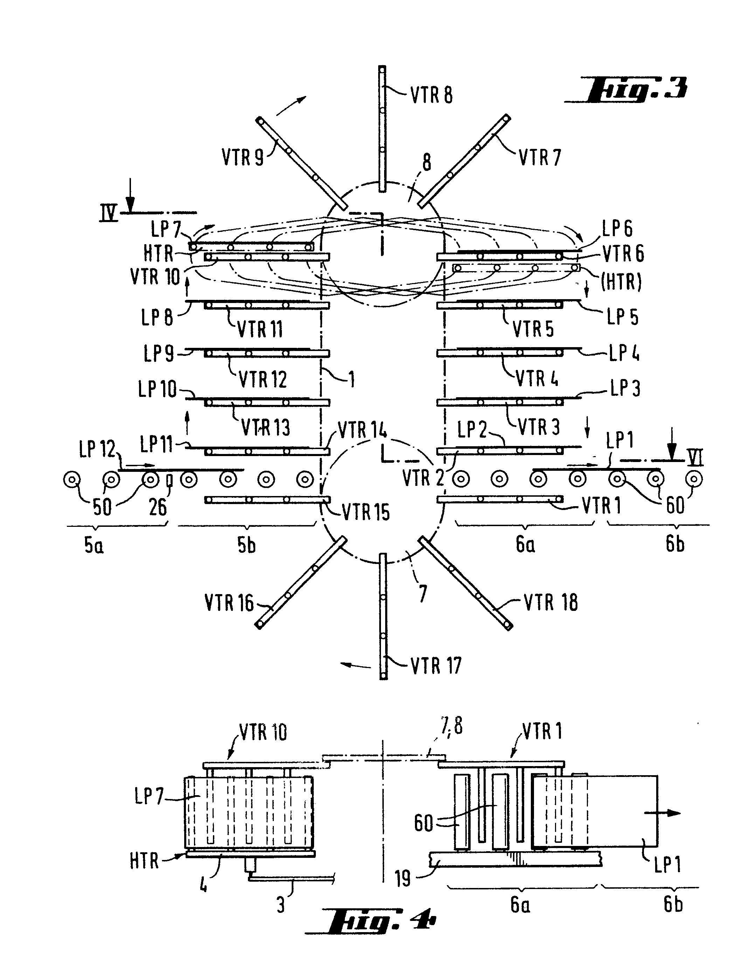

Der Horizontaltransportrechen HTR besteht gleichfalls aus einem Tragarm 4a mit senkrechten Zinken 4b und ist in der weiter unten anhand der Fig. 3 erläuterten Weise derart mit der Horizontaltransportkette 3 und einem Parallelogrammführungsmechanismus verbunden, das er sich längs seines gesamten Umlaufweges stets in der Horizontallage befindet und seine Zinken 4b dabei stets genau parallel zu den Zinken 2b der Vertikaltransportrechen VTR liegen. Die gegenseitige Anordnung und der Bewegungsablauf der Vertikaltransportrechen VTR und des Horizontaltransportrechen HTR ist außerdem so festgelegt, daß die Zinken 2b und 4b dieser Rechensysteme sich gegenseitig »auf Lücke« durchlaufen. Weiter ist die Übersetzung des Getriebes 14 so gewählt bzw. eingestellt, daß jeder Vertikaltransportrechen VTR knapp vor und nach seiner oberen Umlenkung (Kettenrad 8) vom Horizontaltransportrechen HTR überholt wird. Im dargestellten Ausführungsbeispiel überholt der Horizontaltransportrechen HTR bei jedem seiner Umläuft genau vier Vertikaltransportrechen VTR. Die Anordnung könnte auch mit mehr als einem Horizontaltransportrechen ausgestattet sein, die dann entsprechend ihrer Anzahl langsamer laufen.

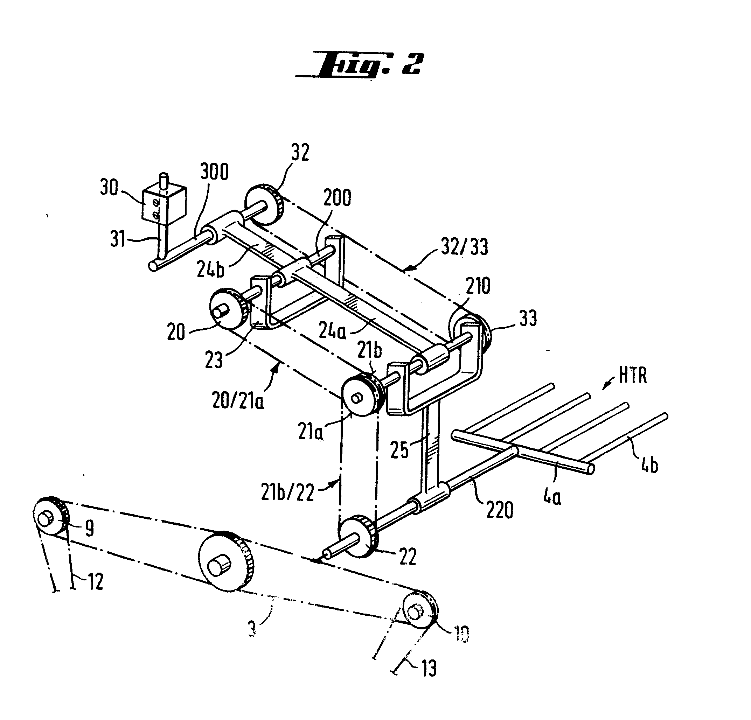

Die Parallelogrammführung des Horizontaltransportrechens HTR umfaßt gemäß Fig. 2 vier Kettenzahnräder 20, 21a, 21b und 22, welche mit ihren Achsen 200, 210 und 220 drehfest verbunden sind. Die Räder 21a und 21b sitzen dabei auf derselben Achse 210 und können als Doppelzahnrad ausgebildet sein. Die Räder 20 und 21a und die Räder 21b und 22 sind mittels je einer Kette 20/21a bzw. 21b/22 miteinander verbunden und bilden so die eigentliche Parallelogrammführung. Die Achse 200 ist mittels eines Lagerbockes 23 drehfest am Maschinengestell (nicht dargestellt) befestigt und trägt andererseits einen zweiarmigen Schwenkhebel 24a/24b. Der darstellungsgemäß rechte Hebelarm 24a ist an seinem Ende gelenkig mit der Achse 210 der beiden mittleren Parallelogramm-Führungsräder 21a und 21b verbunden, an der anderseits ein weiterer Hebel 25 befestigt ist, der mit seinem anderen Ende drehbar mit der Achse 220 des Parallelogramm-Führungsgrades 22 verbunden ist. Die Achse 220 trägt an einem Ende den Horizontaltransportrechen HTR und ist am anderen Ende mit der Antriebskette 3 dieses Rechens mittels einer drehbaren Verbindung auf Mitnahme gekuppelt. Die Achse 220 wird somit von der Kette 3 mitgenommen, wobei sie gleichzeitig durch die Wirkung der durch die Räder 20, 21a/ 21b, 22 und Ketten 20/21a und 21b/22 gebildeten Parallelogrammführung so um ihre eigene Achse gedreht wird, daß der Rechen HTR seine horizontale Stellung ständig beibehält.

Mit 30 ist in Fig. 2 ein Gegengewicht zur Entlastung der Mitnahmeverbindung zwischen der Welle 220 und der Horizontalumlaufkette 3 bezeichnet. Das Gewicht 30 sitzt vorzugsweise verschieb- und in beliebigen Lagen fixierbar auf einer als Hebel wirkenden Stange 31 einer Achse 300, die ihrerseits drehbar mit dem freien Ende des Hebelarmes 24b verbunden ist. Am anderen Ende der Achse 300 ist ein Kettenrad 32 drehfest montiert, das über eine Kette 32/33 mit einem zweiten Kettenrad 33 verbunden ist, welches gleichfalls drehfest auf der Achse 210 sitzt. Durch diese Anordnung wird beim Umlauf der Kette 3 die Welle 300 und damit das an deren Hebelarm 31 sitzende Gegengewicht 30 stets so verdreht, daß der Gewichtsausgleich an jeder Stelle des Umlaufs gewährleistet ist.

Alle Rollen 50 und 60 und Rechen VTR und HTR, die mit dem Transportgut in Berührung kommen, sind mit einem Silikonkautschuk-Schlauch (Wandstärke ca. 1—2 mm) überzogen. Als besonders vorteilhaft haben sich hierzu die Produkte SR50 der Firma Posa und Baysilon® der Firma Bayer erwiesen. Diese lösungsmittelbeständigen Silikonkautschuke haben eine gute Vibrationsdämpfung, schützen das Transportgut (Platten) gegen Verkratzen und bewirken eine sehr gute Adhäsion zwischen den Rollen bzw. Rechen einerseits und dem Transportgut anderseits.

Die Rollen 50 bzw. 60 der Rollenstraßen 5 und 6 sind in einem horizontalen Träger 19 einseitig gelagert, wobei die Rollen 50 bzw. 60 der Gruppen 5b und 6a mit ihren Enden in die »Lücken« der Zinken 2a der Vertikaltransportrechen VTR ragen.

Die Antriebssteuerung erfolgt mittels Näherungsschaltern 26, 27 und 28. Der Näherungsschalter 26 ist zwischen den beiden Rollengruppen 5a und 5b der Eingangs-Rollenstraße 5 angeordnet. Die Näherungsschalter 27 und 28 befinden sich nahe dem Umfang des als Vieleck, darstellungsgemäß Achteck ausgebildeten unteren Umlenk-Kettenrades 7 der Vertikaltransportkette 1. Der Näherungsschalter 26 spricht an, wenn eine über die vom Motor 50a angetriebene Rollengruppe 5a eingezogene Platte mit ihrer Vorderkante seinen Wirkungsbereich erreicht. Die Näherungsschalter 27 und 28 sprechen an, wenn eine Ecke des Umlenk-Kettenrades 7 in ihren Wirkungsbereich gelangt. Die Aufeinanderfolge der Ecken des Umlenk-Kettenrades 7 an den Näherungsschaltern 27 und 28 entspricht genau dem gegenseitigen Abstand der Vertikaltransportrechen VTR auf der Vertikaltransportkette 1. Die Anordnung ist so getroffen, daß der Schalter 27 anspricht, wenn gerade einer der Rechen VTR das Niveau der Rollenstraße 5 verlassen hat, und der Schalter 28 spricht an, wenn gerade einer der Rechen VTR in das Niveau der Rollenstraße 6 eingetaucht ist.

Die Näherungsschalter 26, 27 und 28 steuern über eine nicht dargestellte elektronische Steuervorrichtung den Gesamtablauf der Vorrichtung, wie anschließend anhand der Funktionsbeschreibung ausführlicher erläutert wird.

Die gesamte Transportvorrichtung wird durch Einschalten des Variators 11 in Betrieb gesetzt. Die beschichteten Leiterplatten LP1 bis LP12 usw. (Fig. 3) werden mit der Schichtseite nach oben von einer Zuführeinheit (nicht dargestellt) auf die Rollen 50 der Rollengruppe 5a der Rollenstrasse 5 geschoben. Die Rollengruppe 5a läuft zu diesem Zeitpunkt, angetrieben vom Motor 50a, gleichmäßig langsam. Die Rollengruppe 5a stoppt ihren Vorschub sobald die Leiterplatte LP den Näherungsschalter 26 auslöst. Bei Auslösung des Näherungsschalters 27 (Fig. 1) beschleunigen die Motoren 50a und 50b, und somit die Rollengruppen 5a und 5b auf die Einziehgeschwindigkeit. Die Dauer der Einziehgeschwindigkeit wird durch ein einstellbares Zeitglied bestimmt. Nach der eingestellten Zeit wird der Motor 50b und damit die Rollengruppe 5b gestoppt. Gleichzeitig läuft der Motor 5a wieder an und treibt die Rollengruppe 5a wieder mit der gleichmäßigen langsamen Geschwindigkeit an, bis die nächste Leiterplatte LP13 (nicht dargestellt) in den Wirkungsbereich des Näherungsschalters kommt usw.

Die eingezogene, auf der Rollengruppe 5b stilliegende Leiterplatte LP12 wird nun durch den nächstfolgenden Rechen VTR15 von der Rollengruppe 5b abgehoben und mit konstanter Geschwindigkeit nach oben transportiert.

Bevor die aufwärtsfahrenden Leiterplatten LP den Punkt erreichen, in welchen die Rechen VTR, auf denen sie liegen mit ihrer 180°-Wendung zum absteigenden Teil der Transportbahn beginnen, werden die Rechen VTR vom Rechen HTR überholt. Der Rechen HTR hebt beim Überholen des Rechens VTR die auf diesen liegende Leiterplatte LP ab. Diese Phase ist in Fig. 3 für die gerade von Rechen VTR10 abgehobene und nunmehr am Rechen HTR liegende Leiterplatte LP7 gezeigt. Der parallelogrammgeführte Rechen HTR überholt dann alle im oberen Wendebereich befindlichen Rechen VTR9—VTR7, den Rechen VTR7 zuletzt, wenn dieser den Wendebereich bereits verlassen hat und sich vertikal nach unten bewegt. Beim Überholen des Rechens VTR7 legt der Rechen HTR die auf ihm liegende Leiterplatte LP7 am Rechen VTR7 ab.

In Fig. 3 ist der vorangehende Überhol- und Ablagevorgang dargestellt, in welchem der Rechen HTR die zuvor vom Rechen VTR9 abgehobene Leiterplatte LP6 am Rechen VTR6 abgelegt hat. Die Geschwindigkeit der Rechen VTR zu derjenigen des Rechens HTR ist mittels des Getriebes 14 derart abgestimmt, daß, in der Zeitspanne, in welcher die Rechen VTR eine ihrem gegenseitigen Abstand entsprechende Strecke zurücklegen, der Rechen HTR genau die Hälfte seines gesamten Umlaufweges zurücklegt. Durch einen zusätzlichen Rechen HTR kann deren Umlaufgeschwindigkeit halbiert werden usw.

Die auf den Vertikaltransportrechen VTR abwärtsfahren Leiterplatten LP werden auf die stillstehende Rollengruppe 6a der Rollenstraße 6 abgelegt. Durch den Näherungsschalter 28 (Fig. 1) werden die Motoren 60a und 60b der beiden Rollengruppen 6a bzw. 6b auf die voreingestellte Ausziehgeschwindigkeit gebracht. Die Ausziehzeit wird durch ein einstellbares Zeitglied bestimmt. Nach Ablauf der eingestellten Zeitdauer wird der Motor 60a und damit die Rollengruppe 6a gestoppt und der Motor 60b und damit die Rollengruppe 6b auf eine voreingestellte, langsamere Grundgeschwindigkeit verzögert. Die Leiterplatte LP1 wird durch die Rollengruppe 6b zu einer nächsten Station weitertransportiert.

Zu dem in Fig. 3 dargestellten Zeitpunkt transportieren die Rollen 60 die unmittelbar zuvor vom Vertikaltransportrechen VTR1 auf ihnen abgelegte Leiterplatte LP1 (nach rechts) ab. Es nähert sich bereits der nächste Vertikaltransportrechen VTR2 zur Ablage der Platte LP2 auf den Rollen 60. Dieser Vorgang wiederholt sich anschließend für alle Rechen VTR3 bis VTR18 und alle weiteren Umläufe der Kette 1 periodisch. Die Rollenstraße 6 wird dabei in der bereits beschriebenen Weise vom Näherungsschalter 28 (Fig. 1) gesteuert.

Die dargestellte Transportvorrichtung ist insbesondere zum Einbau in »in die Höhe gebaute« Trockenkammern bestimmt. Die beiden Rollenstraßen 5 und 6 bilden dann den Ein- bzw. Ausgang dieser Kammer.

Bezugszeichenliste

| | |
|---|---|
| 1 | Vertikaltransportkette |
| 1a | Kettenglied |
| 1b | Kettengelenk |
| VTR, VTR1—VTR18 | Vertikaltransportrechen |
| 2a | Tragarm VTR |
| 2b | Zinken VTR |
| 3 | Horizontaltransportkette |
| HTR | Horizontaltransportrechen |
| 4a | Tragarm HTR |
| 4b | Zinken HTR |
| 5 6 | Rollenstraßen (Eingang) |
| 5a, 5b 6a, 6b | Rollengruppen |
| 7 8 9 10 | Umlenk-Kettenräder |
| 11 | Variator (E-Motor mit kont. Drehzahlregelung) |
| 12 | Flachriemen |
| 13 | Antriebskette |
| 14 | Getriebe |
| 15 | Antriebswelle |
| 16 | Antriebskette |
| 17a, 17b | Seitenführungen |
| 19 | Träger für Rollenstraßen (5, 6) |
| 20 21a, 21b 22 | Kettenräder |
| 23 | Lagerblock |
| 24a, 24b | Zweiarmiger Schwenkhebel |
| 25 | Hebel |
| 26 27 28 | Näherungsschalter |
| 30 | Gegengewicht |
| 31 | Stange (Hebel) |
| 32 33 | Kettenräder |
| 32/33 | Kette |
| 50, 60 | Rollen |
| 50a, 50b 60a, 60b | Antriebsmotoren |
| 200 210 220 300 | Achsen (Wellen) |
| LP, LP1 ÷ LP12 | Leiterplatten (Transportgut) |

**Patentansprüche**

1. Transportvorrichtung für einseitig flüssigbeschichtetes flächenförmiges Stückmaterial, wie Platten, Blätter, Folien und dergleichen, mit einer auf- und einer absteigenden Transportstrecke sowie einer dazwischenliegenden, im wesentlichen horizontalen Verbindungsstrecke, bei der die aufsteigende und die absteigende Transportstrecke durch eine einzige, im wesentlichen vertikal oder schräg umlaufende Kette (1) und bei der die aufeinanderfolgenden Träger für die Transportgüter jeweils als aus einem an einem Glied (1a) der Kette (1) befestigten Tragarm (2a) mit senkrecht zu ihm verlaufenden, eine Auflage für das Transportgut bildenden Zinken (2b) bestehender, das Transportgut längs der genützten Transportstrecken stets waagerecht haltender Vertikaltransportrechen (VTR) ausgestaltet sind, dadurch gekennzeichnet, daß die an den Gliedern (1a) der Kette (1) befestigten Tragarme (2a) frei nach außen ragen und parallel zu den Umlenkachsen der Kette verlaufende Zinken (2b) besitzen, und daß die im wesentlichen horizontale Verbindungsstrecke durch wenigstens einen im wesentlichen horizontal umlaufenden gleichartigen Horizontaltransportrechen (HTR) gebildet ist, wobei der (bzw. die) Horizontaltransportrechen (HTR) parallelogrammgeführt und bezüglich der Vertikaltransportrechen so angeordnet und in der Kinematik abgestimmt ist (bzw. sind), daß die beiden Rechensysteme (VTR/HTR) jeweils in den Rechenlücken des anderen verlaufen und daß der (bzw. die) Horizontaltransportrechen (HTR) die Vertikaltransportrechen (VTR) unmittelbar vor und nach deren oberen Umlenkstrecke (Kettenrad 8) überholt (bzw. überholen), so daß er (bzw. sie) dort auf den Vertikaltransportrechen (VTR) liegende Gegenstände vor der Umlenkstrecke abhebt (bzw. abheben) und danach wiederum darauf zurücklegt (bzw. zurücklegen).

2. Vorrichtung gemäß Anspruch 1, dadurch gekennzeichnet, daß die Tragarme (2a) der Vertikaltransportrechen (VTR) jeweils mit der Mitte eines Gliedes (1a) der Umlaufkette (1) starr verbunden sind.

3. Vorrichtung gemäß Anspruch 1 oder 2, dadurch gekennzeichnet, daß die Umlaufkette (1) längs denjenigen Strecken, wo die Vertikaltransportrechen (VTR) beladbar sind, in Führungen (17a und 17b) läuft.

4. Vorrichtung gemäß einem der vorangehenden Ansprüche, dadurch gekennzeichnet, daß die Zuführung und/oder Abführung des Transportgutes mittels Walzentrassen (5 bzw. 6) erfolgt, welche mit frei vorkragenden Walzen (50 bzw. 60) »auf Lücke« zu den Vertikaltransportrechen (VTR) positioniert sind.

**Claims**

1. Conveying apparatus for flat piece goods such as plates, sheets, film, foil and the like, coated on one side with a liquid, with an ascending and descending conveyor segment and an essentially horizontal connecting segment located between said ascending and descending segments, wherein the ascending and the descending conveyor segments are formed by a single, essentially vertically or obliquely revolving chain (1) and wherein the successive carriers for the goods to be conveyed consists of a carrier arm (2a) fastened to a link (1a) of the chain (1) with a vertical transport rake (VTR) consisting of prongs (2b) forming a support for the goods and always maintaining the goods to be conveyed in a horizontal position along the conveyor segment being used, characterized in that the carrier arms (2a) fastened to the links (1a) of the chain (1) protrude freely to the outside and are provided with prongs (2b) extending parallel to the reversing exles of the chain, and that the essentially horizontal connecting segment is formed by at least one similar horizontal transport rake (HTR) revolving essentially horizontally, wherein the horizontal transport rake or rakes (HTR) are parallelogram guided and arranged and kinematically correlated with respect to the vertical transport rake so that the two rake systems (VTR/HTR) are always extending in the rake gaps of the other and that the horizontal transport rake or rakes (HTR) pass the vertical transport rake or rakes (VTR) directly before and after their upper reversing section (chain wheel 8), so that it or they lift the objects resting on the vertical transport rake (VTR) prior to the reversing section and replace them afterwards.

2. Apparatus according to Claim 1, characterized in that the carrier arms (2a) of the vertical transport rake (VTR) are rigidly connected in each case with the center of a link (1a) of the revolving chain (1).

3. Apparatus according to Claim 1 or 2, characterized in that the revolving chain (1) runs in the guides (17a and 17b) along the segments wherein the vertical transport rakes (VTR) may be loaded.

4. Apparatus according to one of the preceding claims, characterized in that the feed and/or removal of the goods to be conveyed is effected by means of roller trains (5 and 6), positioned with protruding rollers (50 and 60) »in gaps« with respect to the vertical transport rakes (VTR).

**Revendications**

1. Dispositif de transport pour matériaux de détail plans recouverts d'une couche liquide sur une face, tels que plaques, feuilles, feuilles métalliques et analogues, comprenant un tronçon de transport ascendant et un tronçon de transport descendant ainsi, qu'entre les deux, un tronçon de raccordement sensiblement horizontal, dans lequel le tronçon de transport ascendant et le tronçon de transport descendant sont formés par une seule chaîne (1) tournant sensiblement verticalment ou obliquement et dans lequel les supports successifs pour les matériaux à transporter sont respectivement réalisés sous la forme d'un rateau de transport vertical (VTR) qui est constitué par un bras-support (2a) fixé à un maillon (1a) de la chaîne (1) et par des dents (2b) disposées perpendiculairement par rapport à lui et formant une surface d'appui pour le matériau à transporter, et qui maintient le matériau à transporter constamment horizontalement le long des trajets de transport utilisés, caractérisé par le fait que les bras-supports (2a) fixés sur les maillons (1a) de la chaîne (1) font librement saillie vers l'extérieur et comportent des dents (2b) disposées parallèlement aux axes de renvoi de la chaîne, et que la tronçon de raccordement sensiblement horizontal est formé par au moins un rateau de transport horizontal (HTR) de même type et tournant sensiblement horizontalement, le (ou les) rateau(x) de transport horizontal (HTR) étant guidé(s) par un parallélogramme et disposé(s) et accordé(s) dans leur cinématique par rapport au rateau de transport vertical de façon que les deux systèmes de rateaux (VTR/HTR) soient toujours disposés en quinconce et que le (ou les) rateaux(x) de transport horizontal (HTR) dépasse(nt) les rateaux de transport vertical (VTR) juste avant et après leur tronçon de renvoi supérieur (roues à chaîne 8) de manière qu'il(s) y soulève(nt) avant le tronçon de renvoi les objets se trouvant sur les rateaux de transport vertical et les redépose(nt) après à nouveau dessus.

2. Dispositif selon la revendication 1, caractérisé par le fait que les bras-supports (2a) des rateaux de transport vertical (VTR) sont respectivement rigidement raccordés au centre d'un maillon (1a) de la chaîne tournante (1).

3. Dispositif selon la revendication 1 ou 2, caractérisé par le fait que la chaîne tournante (1) le long des tronçons où les rateaux de transport vertical (VTR) sont chargés, passe dans des guidages (17a, et 17b).

4. Dispositif selon l'une des revendications précédentes, caractérisé par le fait que l'amenée et ou l'évacuation du matériau à transporter s'effectue au moyen de trains de rouleaux (5, 6) qui, par leurs rouleaux en porte à faux (50, 60) sont disposés »en quinconce« par rapport aux rateaux de transport vertical (VTR).

Fig. 1

Fig. 2

Fig. 3

Fig. 4